# EUROPEAN PATENT APPLICATION

(11) **EP 4 586 791 A1**
(43) Date of publication of application: **16.07.2025**
(21) Application number: 23863336.6
(22) Date of filing: 21.07.2023
(51) Int. Cl.: H10K 71/00, H10K 71/16

(54) **DEPOSITION MASK FOR OLED PIXEL DEPOSITION**

(30) Priority: 08.09.2022 KR 20220114553
(71) Applicant: LG INNOTEK CO., LTD., Seoul 07796 (KR)
(72) Inventor: YOON, Zin Seok, Seoul 07796 (KR); KWON, Ki Young, Seoul 07796 (KR); KWON, Hak Noh, Seoul 07796 (KR)
(74) Representative: Plasseraud IP
(86) International application number: PCT/KR2023/010586
(87) International publication number: WO 2024/053855

(57) **Abstract**

A deposition mask comprising; a metal plate including a deposition region and a non-deposition region, wherein the metal plate has a first direction, which is a longitudinal direction, and a second direction, which is a width direction, defined, wherein the deposition region includes a plurality of effective regions; and a non-effective region, wherein the non-effective region includes a first non-effective region between effective regions, wherein a plurality of through-holes is disposed in the effective region, wherein at least one pattern is disposed in the first non-effective region, wherein the pattern and the through-hole are formed in different shapes.

## Description

### [Technical Field]

An embodiment relates to a deposition mask for OLED pixel deposition.

### [Background Art]

Display devices are applied to various devices. For example, the display device is applied to a small device such as a smart phone or a tablet PC. Alternatively, the display device is applied to a large-sized device such as a TV, monitor, or public display. Recently, the demand for ultra-high definition (UHD) of 500 pixels per inch (PPI) or more is increasing. Accordingly, display devices having high resolution are being applied to small devices and large devices.

Display devices are classified into liquid crystal display (LCD) and organic light emitting diode (OLED) according to driving methods.

The LCD is a display device driven using liquid crystal. In addition, OLED is a display device driven by using an organic material.

The OLED can express an infinite contrast ratio, has a response speed that is 1000 times faster than LCD, and has an excellent viewing angle. Accordingly, the OELD is attracting attention as a display device that can replace the LCD.

The OLED includes a light emitting layer. The light emitting layer includes an organic material. The organic material is deposited on the substrate using a deposition mask. The deposition mask may include an open mask (OM) or a fine metal mask (FMM). A deposition pattern corresponding to a pattern formed on a deposition mask is formed on the substrate. Accordingly, the deposition pattern may serve as a pixel.

The open mask is a thin plate that forms a deposition pattern only at a specific location when manufacturing an OLED. The open mask is used in a deposition process of forming a light emitting layer thereon after a backplane is completed in a display manufacturing process. That is, the open mask is a mask that does not cover a portion within an operating range of the display in order to deposit the entire surface of the display. Therefore, the open mask is used when depositing a light emitting layer with a light emitting material of one color.

On the other hand, the fine metal mask is used to change the color of the sub-pixels of the light emitting layer. Accordingly, the fine metal mask includes ultra-fine holes. The process of using the fine metal mask requires a multi-step deposition process. Therefore, the process requires accurate alignment. Accordingly, the process using the fine metal mask is more difficult than the process using the open mask.

When the light emitting layer of the OLED is deposited using an open mask, only a single-color light emitting layer is formed. Therefore, separate color filters are required to implement various colors. On the other hand, when using the fine metal mask, an RGB light emitting layer may be formed. Therefore, a separate color filter is not required. That is, the technique using the fine metal mask has a high degree of difficulty. However, compared to the method using an open mask, light efficiency is good because a filter for blocking light is not required.

The fine metal mask is generally made of an Invar alloy metal plate including iron (Fe) and nickel (Ni). Through-holes are formed through one surface and the other surface of the metal plate. The through-hole is formed at a position corresponding to the pixel pattern. Accordingly, red, green, and blue organic materials may pass through the through-hole of the metal plate and be deposited on the deposition substrate. Accordingly, a pixel pattern may be formed on the deposition substrate.

Meanwhile, the fine metal mask includes a small surface hole formed on one surface of the metal plate and a large surface hole formed on the other surface of the metal plate. The small face hole and the large surface hole are connected by a connecting portion. As a result, the through-hole is formed.

The organic material is sprayed in the direction of the fine metal mask. The organic material is deposited on the deposition substrate using the large surface hole as an inlet and the small surface hole as an outlet.

In detail, a plurality of strip-shaped fine metal masks are disposed on the deposition substrate. The organic material moves in the direction of the small surface hole through the large surface hole of the plurality of fine metal masks.

The fine metal mask is stretched in the longitudinal direction of the mask and connected to the frame. Thereby, a plurality of fine metal masks is fixed by the frame.

Accordingly, stress is generated in the fine metal mask by the tension. Accordingly, waviness may be formed on the surface of the fine metal mask by the stress.

A distance between the small surface hole and the large surface hole may be changed by the waviness. Accordingly, the position of the organic material deposited by the fine metal mask changes. Accordingly, deposition reliability of the fine metal mask may be reduced.

Accordingly, there is a need for a deposition mask having a new structure capable of solving the above problems.

### [Disclosure]

### [Technical Problem]

The embodiment provides a deposition mask with improved deposition reliability

### [Technical Solution]

A deposition mask comprising; a metal plate including a deposition region and a non-deposition region, wherein the metal plate has a first direction, which is a longitudinal direction, and a second direction, which is a width direction, defined, wherein the deposition region includes a plurality of effective regions; and a non-effective region, wherein the non-effective region includes a first non-effective region between effective regions, wherein a plurality of through-holes is disposed in the effective region, wherein at least one pattern is disposed in the first non-effective region, wherein the pattern and the through-hole are formed in different shapes.

### [Advantageous Effects]

Reliability of the deposition mask according to the embodiment may be improved by the pattern disposed between the effective regions.

The deposition mask is fixed by a mask frame. At this time, the deposition mask is stretched in the longitudinal direction. Accordingly, after the deposition mask is fixed to the mask frame, tensile stress may remain inside the deposition mask. The waviness of the surface of the deposition mask may increase due to residual stress. Accordingly, intervals between effective regions of the deposition mask may be changed. In addition, intervals between through-holes disposed in the effective region may vary.

The deposition mask may include the pattern disposed on the deposition region. In detail, the pattern may be disposed between adjacent effective regions.

The residual stress of the deposition mask may be dispersed by the pattern. Accordingly, the waviness of the deposition mask may be reduced.

Accordingly, variations in the intervals between the effective regions and between the through-holes inside the effective regions are minimized. Thus, the deposition mask has improved deposition reliability.

In addition, the pattern and the through-hole are formed by different processes. Accordingly, the shape and size of the pattern may be formed in various ways. Accordingly, the shape and size of the pattern may be formed in various ways according to the magnitude of tensile force applied to the deposition mask. Accordingly, patterns having various shapes and sizes may be formed according to the size of the deposition mask and the use environment. Accordingly, the deposition mask may have improved deposition reliability.

In addition, a difference in width of the pattern may be small in the thickness direction of the metal plate. Thus, a difference in the amount of metal removed from the first and second surfaces of the deposition mask may be reduced. Accordingly, it is possible to prevent the deposition mask from being bent in one direction due to a difference between residual metals on the first surface and the second surface.

### [Description of Drawings]

FIG. 1 is a view showing a combination of a deposition mask and a frame according to an embodiment.
FIG.2 is a cross-sectional view of an organic material deposition apparatus including the deposition mask according to the embodiment.
FIG. 3 is a view illustrating formation of a deposition pattern on a deposition substrate by through-holes of the deposition mask according to the embodiment.
FIG. 4 is a plan view of the deposition mask according to the embodiment.
FIGS. 5 to 7 are views taken along a region A-A' of FIG. 4.
FIGS. 8 to 23 are plan views of the deposition mask according to other embodiments.

### [Modes of the Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and replaced. In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

Hereinafter, a deposition mask according to an embodiment will be described with reference to the drawings.

The deposition mask described below is a fine metal mask capable of forming an RGB pixel pattern on the deposition substrate by depositing red, green, and blue organic materials on the deposition substrate. In addition, the following description does not apply to the open mask.

In the following description, a first direction 1D is the longitudinal direction of the deposition mask. Also, a second direction 2D is the width direction of the deposition mask.

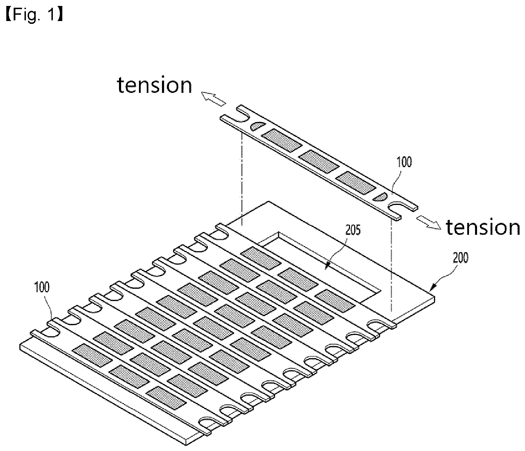

FIGS 1 to 3 are views for explaining a process of depositing an organic material on a deposition substrate 300 using a deposition mask 100 according to an embodiment.

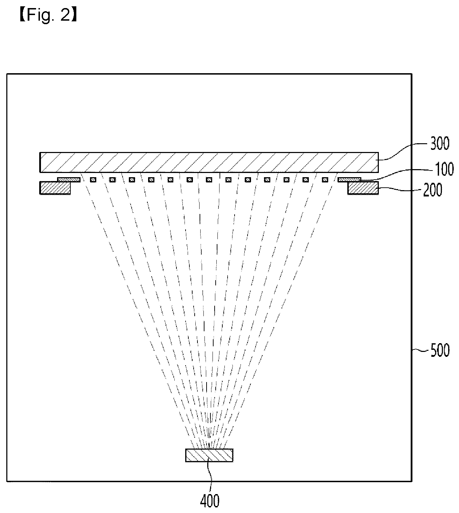

Referring to FIGS. 1 and 2, the organic material deposition apparatus includes a deposition mask 100, a mask frame 200, a deposition substrate 300, an organic material deposition container 400 and a vacuum chamber 500.

The deposition mask 100 includes metal. For example, the deposition mask includes iron (Fe) and nickel (Ni). In detail, the deposition mask includes an invar alloy including iron (Fe) and nickel (Ni).

The deposition mask 100 includes a plurality of through-holes TH. The through-hole is disposed in the effective region. The through-hole is disposed to correspond to a pixel pattern to be formed on the deposition substrate. The deposition mask 100 includes a non-effective region other than an effective region including a deposition region.

That is, the deposition mask 100 may include a metal plate 10, and a plurality of through holes TH may be formed in the metal plate 10.

The mask frame 200 includes an opening 205. The plurality of through-holes are disposed on a region corresponding to the opening 205. Accordingly, the organic material supplied to the organic material deposition container 400 is deposited on the deposition substrate 300. The deposition mask 100 is disposed and fixed on the mask frame 200. For example, the deposition mask 100 is tensioned with a set tensile force. In addition, the deposition mask 100 is welded and fixed on the mask frame 200.

For example, the non-effective region of the deposition mask 100 is welded. Accordingly, the deposition mask 100 is fixed on the mask frame 200. Then, the portion protruding out of the mask frame 200 is cut and removed.

The mask frame 200 includes metal having high rigidity. Thus, deformation of the mask frame during the welding process is reduced.

The deposition substrate 300 is a substrate used when manufacturing a display device. For example, an OLED pixel pattern is formed on the deposition substrate 300. Red, green, and blue organic patterns are formed on the deposition substrate 300 to form pixels that are three primary colors of light. That is, an RGB pattern is formed on the deposition substrate 300.

The organic material deposition container 400 is a crucible. The organic material is disposed inside the crucible. The organic material deposition container 400 moves inside the vacuum chamber 500. That is, the organic material deposition container 400 moves in one direction inside the vacuum chamber 500. For example, the organic material deposition container 400 moves in the width direction of the deposition mask 100 inside the vacuum chamber 500.

A heat source and/or current is supplied to the organic material deposition container 400. As a result, the organic material is deposited on the deposition substrate 300.

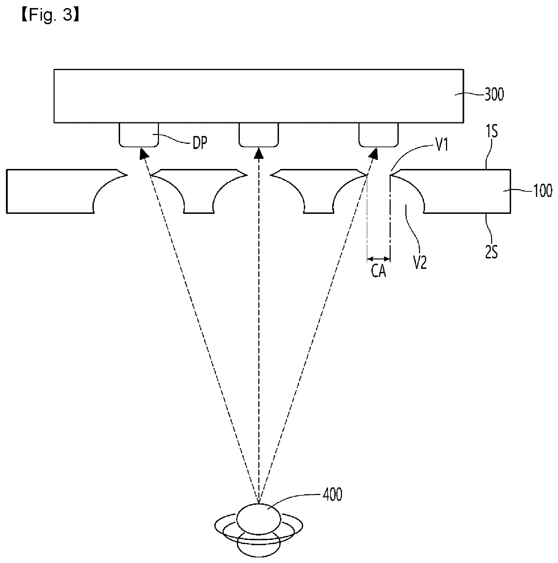

Referring to FIG. 3, the deposition mask 100 includes a metal plate 10. The metal plate includes a first surface 1S and a second surface 2S. The first surface 1S and the second surface 2S are opposite to each other.

The first surface 1S includes a small surface hole V1. The second surface 2S includes a large surface hole V2. For example, a plurality of small surface holes V1 and a plurality of large surface holes V2 are formed on the first surface 1S and the second surface 2S, respectively.

In addition, the deposition mask 100 includes a through-hole TH. The through-hole TH is formed by a connection portion CA connecting the boundary between the small surface hole V1 and the large surface hole V2.

The width of the large surface hole V2 is greater than that of the small surface hole V1. The width of the small surface hole V1 is measured on the first surface 1S of the deposition mask 100. The width of the large surface hole V2 is measured on the second surface 2S of the deposition mask 100.

Also, a width of the connection portion CA has a set size. In detail, the width of the connection portion CA may be 15 µm to 33 µm. In more detail, the width of the connection portion CA may be 19 µm to 33 µm. In more detail, the width of the connection portion CA may be 20 µm to 27 µm. When the width of the connection portion CA exceeds 33 µm, it is difficult to implement a resolution of 500 PPI or higher. In addition, when the width of the connection portion CA is less than 15 µm, defects may occur during the deposition process.

The small surface hole V1 faces the deposition substrate 300. The small surface hole V1 is disposed close to the deposition substrate 300. Accordingly, the small surface hole V1 has a shape corresponding to a deposition pattern DP.

The large surface hole V2 faces the organic material deposition container 400. Accordingly, the organic material supplied from the organic material deposition container 400 may be accommodated in a wide width by the large surface hole V2. In addition, a fine pattern may be rapidly formed on the deposition substrate 300 by the small surface hole V1.

Accordingly, the organic material accommodated by the large surface hole V2 is deposited on the deposition substrate 300 by the small surface hole V1. Accordingly, any one of red, green, and blue pixel patterns is formed on the deposition substrate 300. Then, the above process is repeated. Accordingly, red, green, and blue pixel patterns are all formed on the deposition substrate 300.

As described above, the deposition mask is stretched in one direction to be fixed to the mask frame. In detail, the deposition mask 100 may be stretched in a first direction.

Accordingly, tensile stress is formed inside the deposition mask 100. In addition, after the deposition mask 100 is fixed to the mask frame 200, stress remains inside the deposition mask 100. Waviness formed on the surface of the deposition mask 100 may increase due to residual stress.

Accordingly, the intervals between the effective regions through which the organic material moves may vary. Alternatively, intervals of the through-holes disposed in the effective region may vary. Accordingly, when the deposition pattern is formed on the deposition substrate by the deposition mask, the interval of the deposition pattern may be changed. Accordingly, the deposition reliability of the deposition mask may decrease.

Hereinafter, the deposition mask capable of solving the above problems will be described.

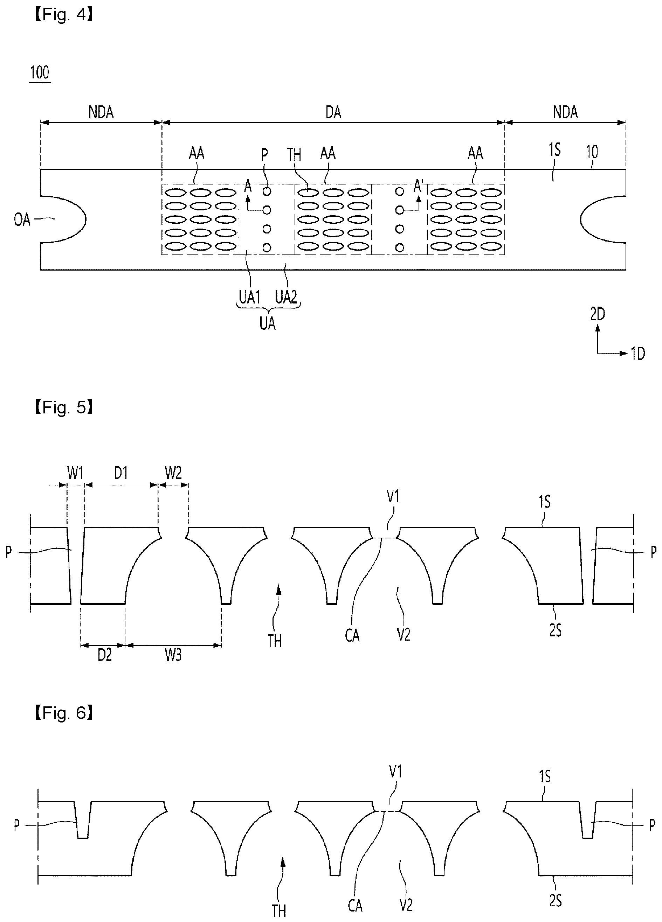

FIG. 4 is a plan view of the deposition mask according to the embodiment. FIGS. 5 to 7 are views taken along a region A-A' of FIG. 4.

Referring to FIGS. 4 to 7, the deposition mask 100 includes a deposition region DA and a non-deposition region NDA.

The deposition region DA is a region for forming the deposition pattern. The deposition region DA includes an effective region AA and a non-effective region UA. The effective region AA is a region where a through-hole TH through which the organic material passes is formed. Also, the non-effective region UA is a region in which the through-hole TH is not formed.

In the drawing, the effective region AA is shown in a square shape. However, the embodiment is not limited thereto. The effective region AA may have a rectangular shape.

The effective region AA may include a plurality of effective regions. The plurality of effective regions are spaced apart in the first direction.

The deposition region DA is a region from the starting point of the first effective region to the ending point of the last effective region in the first direction.

The non-effective region UA is a region other than the effective region AA. The non-effective region UA may be divided into a first non- effective region UA1 and a second non- effective region UA2 according to positions.

The first non-effective region UA1 is a region between the effective regions AA. Accordingly, the plurality of first non-effective regions UA1 are spaced apart in the first direction 1D. Also, the second non-effective region UA2 is a region between the effective region AA and the deposition mask 100. Alternatively, the second non-effective region UA2 is a region between both ends of the metal plate in the second direction.

The non-deposition region NDA is a region not involved in deposition. The non-deposition region NDA includes frame fixing region. The frame fixing region is region for fixing the deposition mask 100 to the mask frame 200. Also, the non-deposition region NDA may include at least one half-etched portion HF and an open portion OA. The half-etched portion HF may be formed by partially etching the metal plate 10. In addition, the open portion OA may be formed by etching all of the metal plate 10.

The half-etched portion HF may disperse stress generated when the deposition mask 100 is stretched. Accordingly, the waviness of the deposition mask may be reduced.

Also, the open portion OA is a region for fixing a jig such as a clamp when the deposition mask 100 is tensioned.

The through-hole TH may be disposed in the effective region AA. In detail, the through-hole TH includes the small surface hole V1, the large surface hole V2, and the connection portion CA. The connection portion CA connects the small surface hole V1 and the large surface hole V2.

A pattern P may be disposed in the non-effective region UA. In detail, a plurality of patterns P may be disposed in the first non-effective region UA1. That is, the pattern P may be disposed between the effective regions AA. That is, the pattern P may be disposed between adjacent effective regions AA.

The pattern P disperses the residual stress of the deposition mask 100. Therefore, the stress of the deposition mask may be relieved. In detail, residual stress generated by tension of the deposition mask 100 may be transferred to the periphery of the pattern P. Accordingly, the residual stress of the deposition mask 100 may be dispersed without being concentrated in one region. Accordingly, the size of the waviness of the deposition mask 100 may be reduced by the pattern P.

Accordingly, a change in intervals between the effective regions and/or a change in intervals between the through-holes disposed inside the effective regions may be reduced. That is, a positional change of the effective regions and a positional change of the through-holes may be reduced.

Accordingly, when forming the deposition pattern on the deposition substrate using the deposition mask 100, the deposition pattern may be formed at a desired location of the deposition substrate 300. Accordingly, the deposition mask according to the embodiment may have improved deposition reliability.

The pattern P and the through-hole TH may be formed in different shapes. For example, the pattern P and the through-hole TH may have different widths. In addition, the pattern P and the through-hole TH may have different shapes of inner surface.

For example, a width of the through-hole TH and a width of the pattern P may change while extending in the thickness direction of the metal plate 10. In this case, a change in the width of the through-hole TH may be greater than a change in the width of the pattern P. That is, a difference between the maximum width and the minimum width of the through-hole TH may be greater than a difference between the maximum width and the minimum width of the pattern P.

For example, the first surface 1S and the second surface 2S of the metal plate 10 are etched to form the small surface hole V1 and the large surface hole V2, respectively. The through-hole TH may be formed by the connection portion CA connecting the small surface hole V1 and the large surface hole V2. For example, the through hole TH may be formed by etching the metal plate 10 using an etchant.

Accordingly, the inner surface of the through-hole TH may have a curvature. Accordingly, the width of the through-hole TH may change while extending from the first surface 1S to the second surface 2S.

Also, the pattern P may be formed by etching the first surface 1S or the second surface 2S of the metal plate 10. For example, the pattern P may be formed using a laser. For example, the pattern P may be formed by irradiating a laser in a direction of the first surface 1S or the second surface 2S.

Accordingly, an angle of the inner surface of the through-hole TH may be greater than an angle of the inner surface of the pattern P.

Referring to FIG. 5, the pattern P may be formed by penetrating the first surface 1S and the second surface 2S. In detail, the laser is irradiated in the direction of the first surface 1S or the second surface 2S and penetrates the metal plate 10. Accordingly, the pattern P may be formed in a hole shape. That is, the pattern P may be a hole formed in the deposition mask 100.

Since the pattern P is formed in a hole shape, the residual stress of the first surface 1S and the second surface 2S may be dispersed by the pattern P. Accordingly, the waviness of the first surface 1S and the second surface 2S may be reduced.

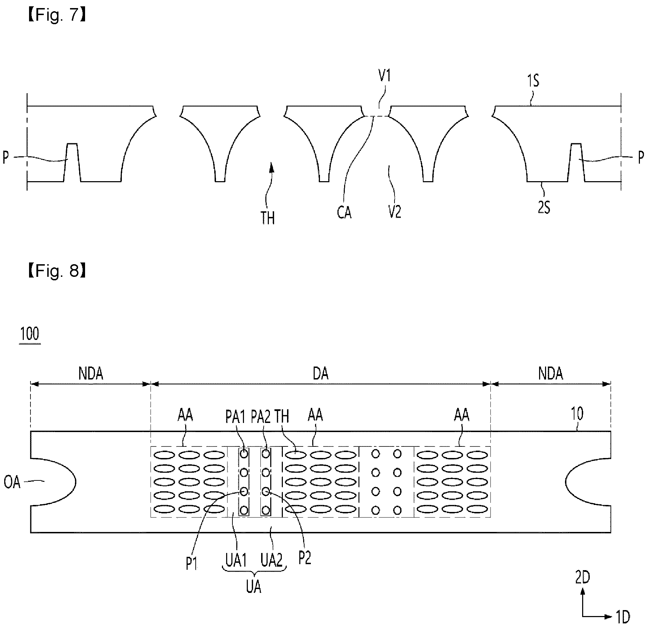

Alternatively, referring to FIGS. 6 and 7, the pattern P may be formed by partially removing the first surface 1S or the second surface 2S. In detail, the laser may be irradiated in the direction of the first surface 1S or the second surface 2S to partially remove the first surface 1S or the second surface 2S. Accordingly, the pattern P may be formed in a groove shape. That is, the pattern P may be a groove formed in the deposition mask 100.

Accordingly, the inner surface of the pattern P may have a flat surface. Accordingly, the change in the width of the pattern P may be small while extending from the first surface 1S to the second surface 2S.

Since the pattern P is formed in the groove shape, the residual stress of the first surface 1S or the second surface 2S may be dispersed by the pattern P. In addition, it is possible to prevent the strength of the deposition mask from decreasing due to the pattern P. In addition, when the pattern P is formed on the first surface 1S where the small surface hole V1 is formed, the difference in the amount of metal remaining on the first surface 1S and the second surface 2S may be reduced. Accordingly, it is possible to prevent the deposition mask from being bent in one direction.

The width W1 of the pattern P may have a set size. The width W1 of the pattern P may be different from a width W2 of the small surface hole V1. For example, the width W1 of the pattern P may be smaller than the width W2 of the small surface hole W1.

Alternatively, the width W1 of the pattern P may be different from the width W3 of the large surface hole V2. For example, the width W1 of the pattern P may be smaller than the width W3 of the large surface hole V2.

Here, the width W1 of the pattern P means the maximum width among the widths of the pattern P. The width W2 of the small surface hole V1 means the maximum width among the widths of the small surface hole V1. The width W3 of the large surface hole V2 means the maximum width among the widths of the large surface hole V2.

Alternatively, the width W1 of the pattern P may be different from a first distance D1 between the pattern P and the small surface hole V1 in the first direction. For example, the width W1 of the pattern P may be smaller than the first distance D1.

Alternatively, the width W1 of the pattern P may be different from a second distance D2 between the pattern P and the large surface hole V2 in the first direction. For example, the width W1 of the pattern P may be smaller than the second distance D2.

For example, the width W1 of the pattern P may be 0.005 mm to 20 mm. In addition, the inclination angle of the inner surface of the pattern P may be 60° or more.

Since the pattern P has the set width as described above, the deposition reliability of the deposition mask may be improved. In detail, when the width of the pattern P is formed to be large, a distance between the pattern P and the effective region AA may be very small due to an error during a process. Alternatively, the pattern P may be partially formed inside the effective region AA.

Accordingly, the organic material may move through the pattern P. Accordingly, the quality of the deposition pattern may be reduced. Therefore, in the deposition mask according to the embodiment, the deposition reliability of the deposition mask may be improved by setting the width of the pattern as described above.

The deposition mask according to the embodiment has improved deposition reliability by the pattern.

The deposition mask is fixed by a mask frame. At this time, the deposition mask is stretched in the longitudinal direction. Accordingly, after the deposition mask is fixed to the mask frame, tensile stress may remain inside the deposition mask. The waviness of the surface of the deposition mask may increase due to residual stress. Accordingly, intervals between effective regions of the deposition mask may be changed. In addition, intervals between through-holes disposed in the effective region may vary.

The deposition mask may include the pattern disposed on the deposition region. In detail, the pattern may be disposed between adjacent effective regions.

Residual stress of the deposition mask may be dispersed by the pattern. Accordingly, the waviness of the deposition mask may be reduced.

Accordingly, variations in the interval between the effective region and interval between the through-holes within the effective regions are minimized. Thus, the deposition mask has improved deposition reliability.

In addition, the pattern and the through-hole are formed by different processes. Accordingly, the shape and size of the pattern may be formed in various ways. Accordingly, the shape and size of the pattern may be formed in various ways according to the magnitude of tensile stress applied to the deposition mask. Accordingly, patterns having various shapes and sizes may be formed according to the size of the deposition mask and the use environment. Accordingly, the deposition mask may have improved deposition reliability.

In addition, the difference in width of the pattern may be small in the thickness direction of the metal plate. Thus, the difference in the amount of metal removed from the first and second surfaces of the deposition mask may be reduced. Accordingly, it is possible to prevent the deposition mask from being bent in one direction due to a difference between residual metals on the first surface and the second surface.

Hereinafter, various arrangements and shapes of patterns of deposition masks according to other embodiments will be described with reference to FIGS. 8 to 20. In the description of the deposition mask according to another embodiment, the same or similar description as the deposition mask according to the above-described embodiment will be omitted. In addition, the same reference numerals are attached to the same components.

Referring to FIG. 8, the deposition mask 100 may include a plurality of pattern portions. For example, the deposition mask 100 may include a first pattern portion PA1 and a second pattern portion PA2. FIG. 8 shows only the first pattern portion PA1 and the second pattern portion PA2 for convenience of explanation. However, the embodiment is not limited thereto. The deposition mask may include three or more pattern portions.

The first pattern portion PA1 may include a plurality of first patterns P1. The plurality of first patterns P1 may be spaced apart in the second direction 2D. The second pattern portion PA2 may include a plurality of second patterns P2. The plurality of second patterns P2 may be spaced apart in the second direction 2D.

The first pattern portion PA1 and the second pattern portion PA2 may be spaced apart from each other in the first direction 1D.

The deposition mask 100 according to another embodiment includes the first pattern portion PA1 and the second pattern portion PA2. Accordingly, patterns may be formed in various positions of the first non-effective region UA1. Accordingly, the waviness of the deposition mask is reduced. Accordingly, deposition reliability of the deposition mask may be improved.

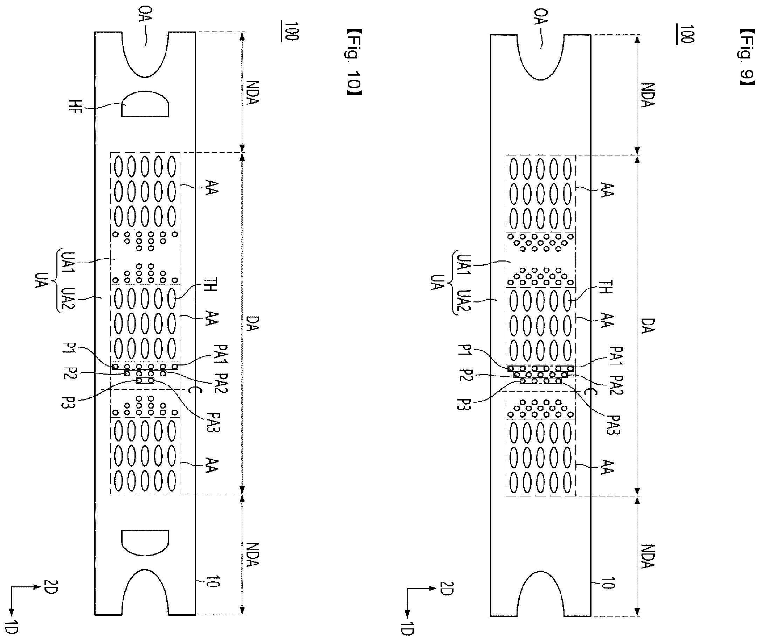

Referring to FIGS. 9 and 10, the deposition mask 100 may include a plurality of pattern portions. For example, the deposition mask 100 may include a first pattern portion PA1, a second pattern portion PA2, and a third pattern portion PA3. FIGS. 9 and 10 show only the first pattern portion PA1, the second pattern portion PA2, and the third pattern portion PA3 for convenience of explanation. However, the embodiment is not limited thereto. The deposition mask may include four or more pattern portions.

The first pattern portion PA1 may include a plurality of first patterns P1. The plurality of first patterns P1 may be spaced apart in the second direction 2D. The second pattern portion PA2 may include a plurality of second patterns P2. The plurality of second patterns P2 may be spaced apart in the second direction 2D. The third pattern portion PA3 may include a plurality of third patterns P3. The plurality of third patterns P3 may be spaced apart in the second direction 2D.

The first pattern portion PA1, the second pattern portion PA2, and the third pattern portion PA3 may be spaced apart from each other in the first direction 1D.

Referring to FIG. 9, patterns of the first pattern portion PA1, the second pattern portion PA2, and the third pattern portion PA3 may be disposed in a zigzag pattern. That is, the second pattern P2 is disposed between adjacent first patterns P1. Also, the third pattern P3 is disposed between adjacent second patterns P2.

Alternatively, referring to FIG. 10, patterns of the first pattern portion PA1, the second pattern portion PA2, and the third pattern portion PA3 may be disposed in the first direction 1D. That is, patterns of the first pattern portion PA1, the second pattern portion PA2, and the third pattern portion PA3 may face each other in the first direction 1D.

Also, the deposition mask 100 may include a half-etched portion HF disposed in the non-deposition region NDA. The half-etched portion HF may be formed by partially removing the first surface 1S of the metal plate 10. That is, the half-etched part HF may be a groove formed in the first surface 1S.

The half-etched portion HF may disperse stress in the non-deposition region NDA. Accordingly, the waviness of the non-deposited region NDA may be reduced. Accordingly, when an organic material is deposited on the deposition substrate using the deposition mask 100, formation of a gap between the deposition mask and the deposition substrate may be prevented.

Accordingly, it is possible to prevent an increase in the distance between the small surface hole V1 and the deposition substrate 300. Accordingly, the reduction in deposition quality due to the shadow effect may be prevented.

The number of patterns of the first pattern portion PA1, the second pattern portion PA2, and the third pattern portion PA3 may be different. In detail, the number of the first pattern P1, the second pattern P2, and the third pattern P3 may be different. In more detail, the number of the first patterns P1 may be greater than the numbers of the second patterns P2 and the third patterns P3. Also, the number of the second patterns P2 may be greater than the number of the third patterns P3.

Accordingly, the number of patterns may decrease while extending from the effective region AA to the central portion C of the first non-effective region UA1. That is, the area of the opening region formed by the pattern may decrease while extending from the effective region AA to the central portion C of the first non-effective region UA1.

Accordingly, the number of patterns and the area of the opening region may decrease while extending from the outside to the inside of the first non-effective region UA1 in the first direction 1D. Also, the number of patterns and the area of the opening region may increase while extending from the outside to the inside of the first non-effective region UA1 in the second direction 2D.

In the deposition mask according to another embodiment, the number of patterns and the area of the opening region decrease while extending from the outside to the inside of the first non-effective region UA1 in the first direction 1D. Therefore, the effect of dispersing stress in the region adjacent to the effective region is increased. Therefore, the waviness of the region adjacent to the effective region is reduced. Accordingly, positional changes of the through-holes are reduced.

In addition, in the deposition mask according to another embodiment, the number of patterns and the area of the opening region increase while the first non-effective region UA1 extends from the outside to the inside in the second direction 2D. Accordingly, residual stress in the outer and central portions of the deposition mask in the second direction may be similarly formed.

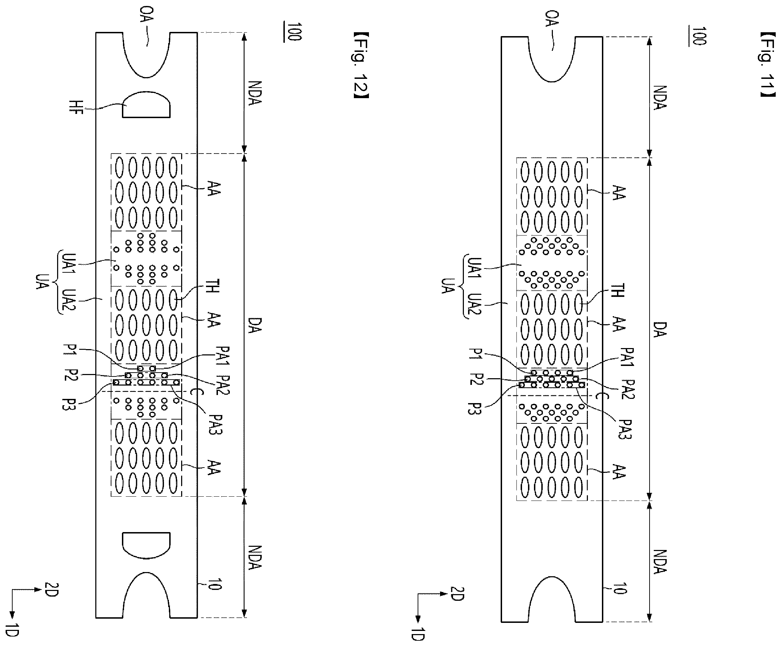

Referring to FIGS. 11 and 12, the deposition mask 100 may include a plurality of pattern portions. For example, the deposition mask 100 may include a first pattern portion PA1, a second pattern portion PA2, and a third pattern portion PA3. In FIGS. 11 and 12 shows only the first pattern portion PA1, the second pattern portion PA2, and the third pattern portion PA3 for convenience of explanation. However, the embodiment is not limited thereto. The deposition mask may include four or more pattern portions.

The first pattern portion PA1 may include a plurality of first patterns P1. The plurality of first patterns P1 may be spaced apart in the second direction 2D. The second pattern portion PA2 may include a plurality of second patterns P2. The plurality of second patterns P2 may be spaced apart in the second direction 2D. The third pattern portion PA3 may include a plurality of third patterns P3. The plurality of third patterns P3 may be spaced apart in the second direction 2D.

The first pattern portion PA1, the second pattern portion PA2, and the third pattern portion PA3 may be spaced apart from each other in the first direction 1D.

Referring to FIG. 11, patterns of the first pattern portion PA1, the second pattern portion PA2, and the third pattern portion PA3 may be disposed in a zigzag pattern. That is, the second pattern P2 is disposed between adjacent first patterns P1. Also, the third pattern P3 is disposed between adjacent second patterns P2.

Alternatively, referring to FIG. 12, patterns of the first pattern portion PA1, the second pattern portion PA2, and the third pattern portion PA3 may be disposed in the first direction 1D. That is, patterns of the first pattern portion PA1, the second pattern portion PA2, and the third pattern portion PA3 may face each other in the first direction 1D.

The number of patterns of the first pattern portion PA1, the second pattern portion PA2, and the third pattern portion PA3 may be different. In detail, the number of the first pattern P1, the second pattern P2, and the third pattern P3 may be different. In more detail, the number of the first patterns P1 may be smaller than the numbers of the second patterns P2 and the third patterns P3. Also, the number of the second patterns P2 may be smaller than the number of the third patterns P3.

Accordingly, the number of patterns may increase while extending from the effective region AA to the central portion C of the first non-effective region UA1. That is, the area of the opening region due to the pattern may increase while extending from the effective region AA to the central portion C of the first non-effective region UA1.

Accordingly, the number of patterns and the area of the opening region may increase while extending from the outside to the inside of the first non-effective region UA1 in the first direction 1D. Also, the number of patterns and the area of the opening region may increase while extending from the outside to the inside of the first non-effective region UA1 in the second direction 2D.

In the deposition mask according to another embodiment, the number of patterns and the area of the opening region increase while extending from the outside to the inside of the first non-effective region UA1 in the first direction 1D. Accordingly, the stress dispersing effect in the central portion of the first non-effective region is increased. Accordingly, the waviness of the first non-effective region may be reduced. Therefore, the change in interval between the effective regions is reduced.

Also, in the deposition mask according to another embodiment, the number of patterns and the area of the opening region increase while extending from the outside to the inside of the first non-effective region UA1 in the second direction 2D. Accordingly, residual stress in the outer and central portions of the deposition mask in the second direction may be similarly formed.

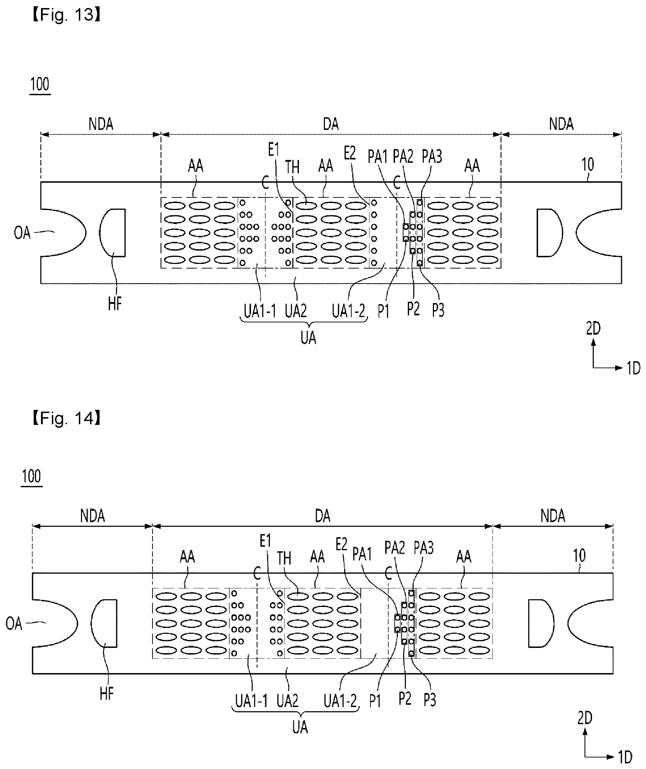

Referring to FIGS. 13 and 14, the deposition mask 100 may include a plurality of pattern portions. For example, the deposition mask 100 may include a first pattern portion PA1, a second pattern portion PA2, and a third pattern portion PA3. In FIGS. 13 and 14 show only the first pattern portion PA1, the second pattern portion PA2, and the third pattern portion PA3 for convenience of description. However, the embodiment is not limited thereto. The deposition mask may include four or more pattern portions.

The first pattern portion PA1 may include a plurality of first patterns P1. The plurality of first patterns P1 may be spaced apart in the second direction 2D. The second pattern portion PA2 may include a plurality of second patterns P2. The plurality of second patterns P2 may be spaced apart in the second direction 2D. The third pattern portion PA3 may include a plurality of third patterns P3. The plurality of third patterns P3 may be spaced apart in the second direction 2D.

The first pattern portion PA1, the second pattern portion PA2, and the third pattern portion PA3 may be spaced apart from each other in the first direction 1D.

At least one effective region AA among the plurality of effective regions AA may define two non-effective regions disposed at both ends in the first direction 1D. The number of pattern portions and the number of patterns in a region adjacent to the effective region in the center of the two non-effective regions may be different. That is, the areas of the opening regions disposed at both ends of the effective region AA in the first direction 1D may be different.

Referring to FIG. 13, the first pattern portion PA1, the second pattern portion PA2, and the third pattern portion PA3 may be disposed in a region adjacent to the first end E1 of the effective region AA. In addition, only the first pattern portion PA1 may be disposed in a region adjacent to the second end E2 of the effective region AA.

Alternatively, referring to FIG. 14, the first pattern portion PA1 and the second pattern portion PA2 may be disposed in the region adjacent to the first end E1 of the effective region AA. In addition, the pattern portion may not be disposed in the region adjacent to the second end E2 of the effective region AA.

A region adjacent to the end of the effective region AA is a region between the effective region AA and the central portion of the first non-active region UA1.

Accordingly, the number of patterns disposed in the region adjacent to the first end E1 of the effective region AA is different from the number of patterns disposed in the region adjacent to the second end E2 of the effective region AA. That is, the area of the opening region disposed in the region adjacent to the first end E1 of the effective region AA may be different from the area of the opening region disposed in the region adjacent to the second end E2 of the effective region AA.

Also, the number of patterns disposed in the plurality of first non-effective regions UA1 or the area of the opening region may be different from each other.

Referring to FIGS. 13 and 14, the first non-effective region UA1 may include a 1-1 un-effective region UA1-1 and a 1-2 non-effective region UA1-2 spaced apart in the first direction. That is, the effective region AA may be disposed between the 1-1 non-effective region UA1-1 and the 1-2 non-effective region UA1-2. In detail, one effective region may be disposed between the 1-1 non-effective region UA1-1 and the 1-2 non-effective region UA1-2.

The number of patterns disposed in the 1-1 non-effective region UA1-1 and the number of patterns disposed in the 1-2 non-effective region UA1-2 may be different. For example, the number of patterns disposed in the 1-1 non-effective region UA1-1 may be greater than the number of patterns disposed in the 1-2 non-effective region UA1-2. That is, the area of the opening region of the 1-1 non-effective region UA1-1 may be larger than the area of the opening region disposed in the 1-2 non-effective region UA1-2.

In the deposition mask according to another embodiment, the number of patterns and the area of the opening region disposed in regions adjacent to both ends of the effective region may be different. Alternatively, the number of patterns and the area of the opening region disposed in each of the first non-effective regions may be different.

The through-hole, the pattern, and the opening region are formed in the metal plate. A rolling process may be performed before forming through-holes, patterns, and opening regions in the metal plate. In this way, the thickness of the metal plate may be formed to a set thickness.

Stress is generated inside the metal plate by the rolling process. In addition, a waviness may be formed on the surface of the metal plate by the stress.

Therefore, before forming through-holes, patterns, and opening regions in the metal plate, the waviness distribution of the metal plate is measured. Subsequently, the number of patterns to be formed in a region with a large waviness and a region with a small waviness may be different.

For example, many patterns are formed in a region having a large waviness. In addition, a small number of patterns are formed in a region having a small waviness. Accordingly, it is possible to reduce waviness caused by tensile stress generated when the deposition mask is stretched.

That is, many patterns are formed in the region with a large waviness, and fewer patterns are formed in the region with a small waviness. Thereby, the area of the opening region of the region where the waviness is small is relatively reduced to disperse the tensile stress. Accordingly, after the deposition mask is fixed to the mask frame, further increase in waviness due to the raw material characteristics of the metal plate may be prevented.

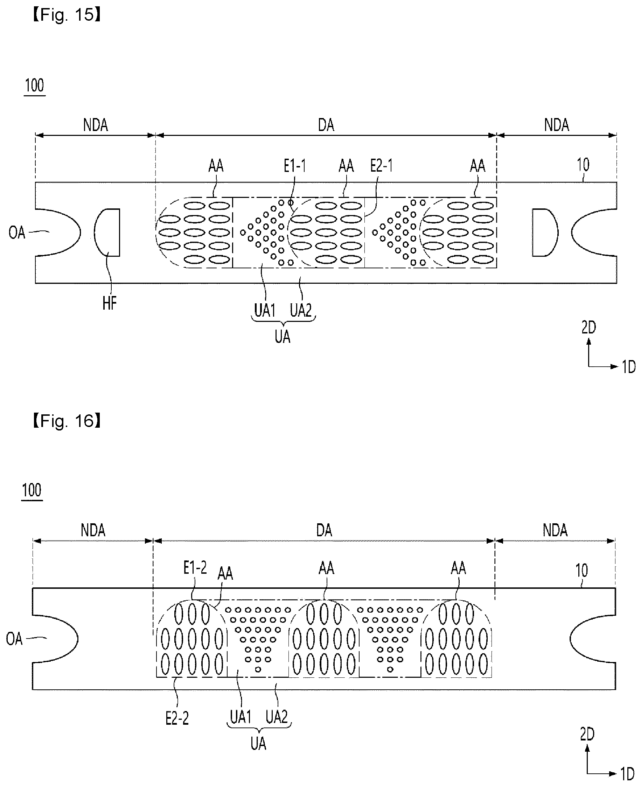

Referring to FIGS. 15 and 16, a shape of the effective region AA may be different.

In detail, a width of the effective region AA may be changed while extending in one direction. In detail, the width of at least one effective region among the plurality of effective regions may change.

For example, referring to FIG. 15, the width of the effective region AA may change while extending in the first direction 1D.

Alternatively, referring to FIG. 16, the width of the effective region AA may change while extending in the second direction 2D.

That is, the effective region AA of the deposition mask 100 may be formed in various shapes. Accordingly, patterns deposited on the deposition substrate 300 may be formed in various designs.

The deposition mask 100 may include a plurality of patterns P. The number of the patterns P may change while moving away from one end of the effective region AA.

For example, referring to FIG. 15, the width of the effective region AA is narrowed while extending from the 1-2 end E1-2 toward the 1-1 end E1-1. In addition, the number of patterns P decreases from the 1-2 end E1-2 toward the 1-1 end E1-1.

Alternatively, referring to FIG. 16, the width of the effective region AA is narrowed while extending from the 2-2 end E2-2 toward the 1-2 end E1-2. In addition, the number of patterns P increases from the 2-2 end E2-2 toward the 1-2 end E1-2.

Accordingly, in the deposition mask according to another embodiment, the pattern may be variously disposed according to the shape of the effective region AA. Therefore, even if the shape of the effective region AA changes, the residual stress may be effectively dispersed by the pattern. Accordingly, the waviness of the deposition mask may be reduced. Accordingly, the deposition reliability of the deposition mask may be improved.

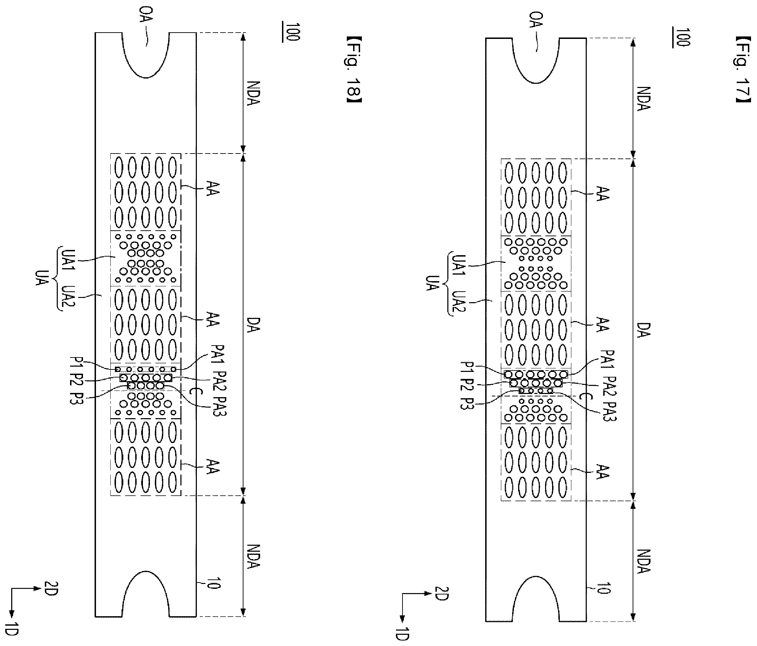

Referring to FIGS. 17 to 20, the deposition mask 100 according to another embodiment may include a plurality of pattern portions. For example, the deposition mask 100 may include a first pattern portion PA1, a second pattern portion PA2, and a third pattern portion PA3. In FIGS. 17 to 20 show only the first pattern portion PA1, the second pattern portion PA2, and the third pattern portion PA3 for convenience of description. However, the embodiment is not limited thereto. The deposition mask may include four or more pattern portions.

The first pattern portion PA1 may include a plurality of first patterns P1. The plurality of first patterns P1 may be spaced apart in the second direction 2D. The second pattern portion PA2 may include a plurality of second patterns P2. The plurality of second patterns P2 may be spaced apart in the second direction 2D. The third pattern portion PA3 may include a plurality of third patterns P3. The plurality of third patterns P3 may be spaced apart in the second direction 2D.

The first pattern portion PA1, the second pattern portion PA2, and the third pattern portion PA3 may be spaced apart from each other in the first direction 1D.

The size of the pattern may change while extending in one direction. In detail, the size of the pattern may change while extending in the first direction 1D.

Referring to FIG. 17, patterns of the first pattern portion PA1, the second pattern portion PA2, and the third pattern portion PA3 may have different sizes. In detail, the size of the first pattern P1 may be larger than the sizes of the second pattern P2 and the third pattern P3. Also, the size of the second pattern P2 may be larger than that of the third pattern P3.

That is, the size of the pattern may decrease while extending from the end of the effective region toward the central portion C of the first non-effective region UA1.

Alternatively, referring to FIG. 18, the size of the first pattern P1 may be smaller than the sizes of the second pattern P2 and the third pattern P3. Also, the size of the second pattern P2 may be smaller than that of the third pattern P3.

That is, the size of the pattern may increase while extending from the end of the effective region toward the central portion C of the first non-effective region UA1.

Alternatively, the interval of the patterns may vary while extending in one direction. In detail, the interval of the pattern may change while extending in the first direction 1D.

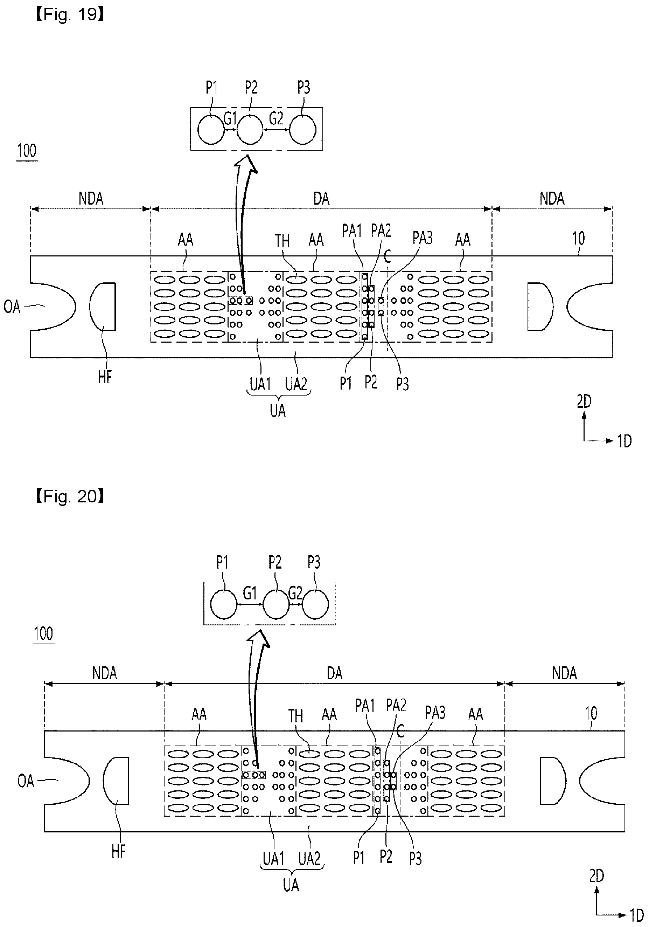

Referring to FIG. 19, the distance G1 between the first pattern P1 and the second pattern P2 may be smaller than the distance G2 between the second pattern P2 and the third pattern P3.

That is, the interval of the patterns may increase while extending from the end of the effective region toward the central portion C of the first non-effective region UA1.

Alternatively, referring to FIG. 20, the distance G1 between the first pattern P1 and the second pattern P2 may be greater than the distance G2 between the second pattern P2 and the third pattern P3.

That is, the interval between the patterns may decrease while extending from the end of the effective region toward the central portion C of the first non-effective region UA1.

In addition, although not shown in the drawing, both the size and interval of the pattern may change while extending in the first direction 1D.

In the deposition mask according to another embodiment, the size and interval of the pattern may be varied.

Accordingly, many patterns may be formed in a region adjacent to the effective region. Alternatively, many patterns may be formed in a region far from the effective region.

The metal plate may have different physical properties depending on the manufacturing process or the properties of raw materials. Accordingly, residual stress may be concentrated in a central region or an outer region of the deposition mask.

Therefore, the size and interval of the patterns are disposed in various ways. Accordingly, the position of the pattern may be controlled according to the physical characteristics of the metal plate. Therefore, the tensile stress caused by the tension of the deposition mask is effectively dispersed. Accordingly, the waviness of the deposition mask is reduced. Accordingly, the deposition mask may have improved deposition reliability.

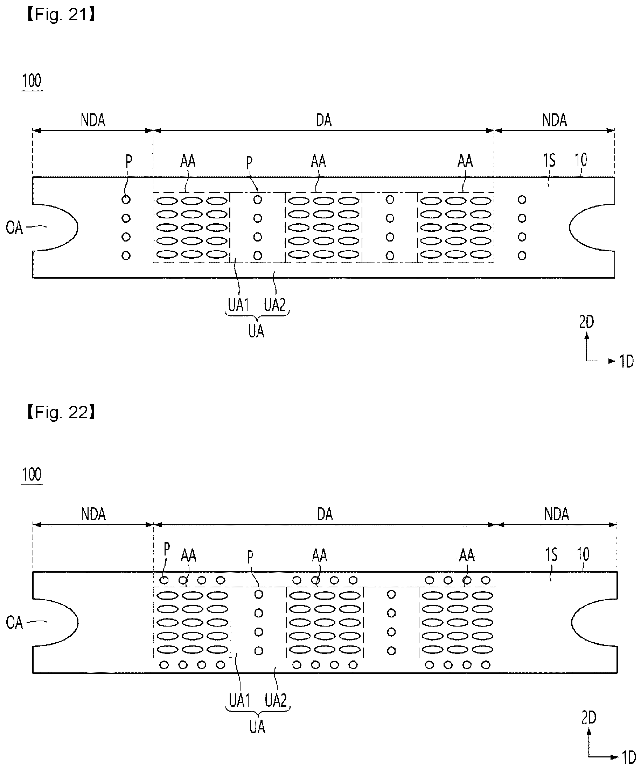

Referring to FIGS. 21 and 22, the pattern portion may be formed in a region other than the effective region AA.

Referring to FIG. 21, the pattern P may be formed in the non-deposition region NDA. Accordingly, the pattern P may be formed between the open portion OA and the effective region AA.

Accordingly, the residual stress may be effectively dispersed in the non-deposition region NDA. In addition, a process of forming a separate half-etched portion in the non-deposition region NDA may be omitted.

Referring to FIG. 22, the pattern P may be formed in the second non-effective region UA2. That is, the pattern P may be formed between the effective region AA and an end of the deposition mask 100 in the second direction.

Accordingly, the pattern P may also be formed in a region outside the deposition region DA.

Accordingly, the residual stress may be effectively dispersed in a region outside the deposition region NDA. In addition, it is possible to prevent an increase in the distance between the small surface hole V1 and the deposition substrate 300. Accordingly, it is possible to prevent a decrease in deposition quality due to a shadow effect.

Also, although not shown in the drawing, the pattern P may be formed in both the non-deposited region NDA and the second non-effective region UA2.

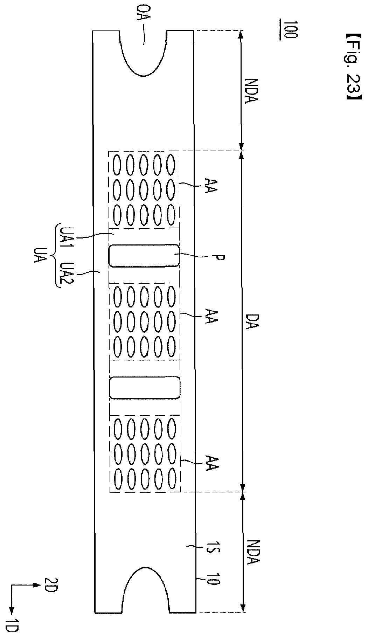

Referring to FIG. 23, one pattern P may be formed between the effective regions.

An area of the pattern P may be smaller than an area of the first non-effective region UA1. In detail, the area of the pattern P may be 90% or less, 80% or less, 70% or less, or 60% or less of the area of the first non-effective region UA1. For example, the area of the pattern P may be 50% to 90% of the area of the first non-effective region UA1.

When the area of the pattern P exceeds 90% of the area of the first non-effective region UA1, one area of the pattern P may be disposed inside the effective region AA due to an error during the process. Accordingly, the deposition reliability of the deposition mask may be reduced.

In addition, when the area of the pattern P is less than 50% of the area of the first non-effective region UA1, the residual stress may not be effectively distributed between the effective regions by the pattern P. Accordingly, the waviness of the deposition mask may increase. Accordingly, the deposition reliability of the deposition mask may be reduced.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. A deposition mask comprising;
a metal plate including a deposition region and a non-deposition region,
wherein the metal plate has a first direction, which is a longitudinal direction, and a second direction, which is a width direction, defined,
wherein the deposition region includes a plurality of effective regions; and a non-effective region,
wherein the non-effective region includes a first non-effective region between effective regions,
wherein a plurality of through-holes is disposed in the effective region,
wherein at least one pattern is disposed in the first non-effective region,
wherein the pattern and the through-hole are formed in different shapes.

2. The deposition mask of claim 1, wherein the first non-effective region includes a first pattern portion including a plurality of first patterns; and a second pattern portion including a plurality of second patterns,
wherein the first pattern portion and the second pattern portion are spaced apart from each other in the first direction.

3. The deposition mask of claim 1, wherein the first non-effective region includes a first pattern portion including a plurality of first patterns; a second pattern portion including a plurality of second patterns; and a third pattern portion including a plurality of third patterns,
wherein the first pattern portion, the second pattern portion and the third pattern portion are spaced apart from each other in the first direction,
wherein a number of patterns of the first pattern portion, the second pattern portion and the third pattern portion are different.

4. The deposition mask of claim 3, wherein the number of patterns decreases while extending from the outside to the inside of the first non-effective region in the first direction;
wherein the number of patterns increases while extending from the outside to the inside of the first non-effective region in the second direction.

5. The deposition mask of claim 3, wherein the number of patterns increases while extending from the outside to the inside of the first non-effective region in the first direction;
wherein the number of patterns increases while extending from the outside to the inside of the first non-effective region in the second direction.

6. The deposition mask of claim 1, wherein a number of patterns disposed at both ends of the effective region in the first direction is different.

7. The deposition mask of claim 1, wherein the first non-effective region includes a 1-1 non-effective region and a 1-2 non-effective region spaced apart in the first direction with one effective region interposed therebetween,
wherein a number of patterns disposed in the 1-1 non-effective region and a number of patterns disposed in the 1-2 non-effective region are different.

8. The deposition mask of claim 1, wherein a width of at least one effective region among the plurality of effective regions varies while extending in the first direction or the second direction.

9. The deposition mask of claim 1, wherein the first non-effective region includes a first pattern portion including a plurality of first patterns; a second pattern portion including a plurality of second patterns; and a third pattern portion including a plurality of third patterns,
wherein the first pattern portion, the second pattern portion and the third pattern portion are spaced apart from each other in the first direction,
wherein the first pattern, the second pattern, and the third pattern have different sizes.

10. **11.** The deposition mask of claim 9, wherein a size of the pattern decreases or increases while extending from an end of the effective region toward a central portion of the first non-effective region.
